# EUROPEAN PATENT APPLICATION

(11) **EP 2 236 580 A2**
(43) Date of publication of application: **06.10.2010**
(21) Application number: 10007184.4
(22) Date of filing: 02.10.2006
(51) Int. Cl.: C09K 11/64, C09K 11/59

(54) **Nitride and oxy-nitride cerium based phosphor materials for solid-state lighting applications**

(30) Priority: 30.09.2005 US 722682 P; 30.09.2005 US 722900 P
(62) Divisional of application: 06825281.6
(71) Applicant: The Regents of the University of California, Oakland, CA 94607 (US)
(72) Inventor: Le Toquin, Ronan P., Durham, NC 27713 (US); Cheetham, Anthony K., Santa Barbara, CA 93108 (US)
(74) Representative: Jackson, Martin Peter

(57) **Abstract**

Three new cerium (Ce) based phosphor materials based on nitride and oxynitride compounds emit yellow or blue to green photons upon excitation by ultraviolet (UV) or blue light radiation. The two yellow emitting compounds belong to the quartenary Ca-Al-Si-N system with distinct structures. These bright yellow phosphors can be used for white light applications by combining either a blue light emitting diode (LED) and a yellow phosphor, a blue LED and green-orange phosphors, or an ultraviolet (UV) LED with three phosphors, i.e., red, blue and green (RGB) phosphors. The bright blue-green phosphor, which may be described by Sr₂SiO_{4-δ}N_{δ}, can be used in the UV LED plus 3 RGB phosphors setup.

## Description

### CROSS-REFERENCE TO RELATED APPLICATION

This application claims the benefit under 35 U.S.C. Section 119(c) of the following co-pending and commonly-assigned U.S. patent applications:
U.S. Provisional Application Serial No. 60/722,682, filed on September 30, 2005, by Ronan P. Le Toquin and Anthony K. Cheetham, entitled "NITRIDE AND OXY-NITRIDE CERIUM BASED PHOSPHOR MATERIALS FOR SOLID-STATE LIGHTING APPLICATIONS," attorneys' docket number 30794.145-US-P1 (2005-618-1); and
U.S. Provisional Patent Application Serial No. 60/722,900, filed on September 30, 2005, by Anthony K. Cheetham and Ronan P. Le Toquin, entitled "CERIUM BASED PHOSPHOR MATERIALS FOR SOLID-STATE LIGHTING APPLICATIONS," attorneys' docket number 30794.138-US-P1 (2005-618-1).
which applications are incorporated by reference herein.

This application is related to the following co-pending and commonly-assigned applications:
U.S. Utility Application Serial No. xx/xxx,xxx, filed on same date herewith, by Anthony K. Cheetham and Ronan P. Le Toquin, entitled "CERIUM BASED PHOSPHOR MATERIALS FOR SOLID-STATE LIGHTING APPLICATIONS," attorneys' docket number 30794.138-US-U1 (2005-618-2), which application claims priority to U.S. Provisional Patent Application Serial No. 60/722,900, filed on September 30, 2005, by Anthony K. Cheetham and Ronan P. Le Toquin, entitled "CERIUM BASED PHOSPHOR MATERIALS FOR SOLID-STATE LIGHTING APPLICATIONS," attorneys' docket number 30794.138-US-P1 (2005-618-1).
which applications are incorporated by reference herein.

### BACKGROUND OF THE INVENTION

### 1. Field of the Invention.

The present invention relates to cerium (Ce) based phosphor materials for solid-state lighting applications.

### 2. Description of the Related Art.

(Note: This application references a number of different publications as indicated throughout the specification by one or more reference numbers within brackets, e.g., [x]. A list of these different publications ordered according to these reference numbers can be found below in the section entitled "References." Each of these publications is incorporated by reference herein.)

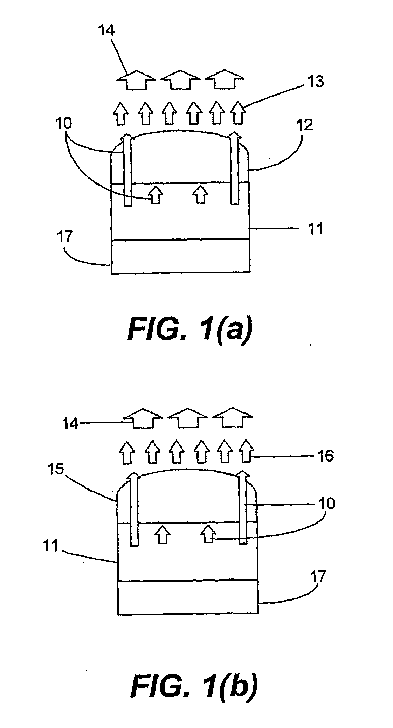

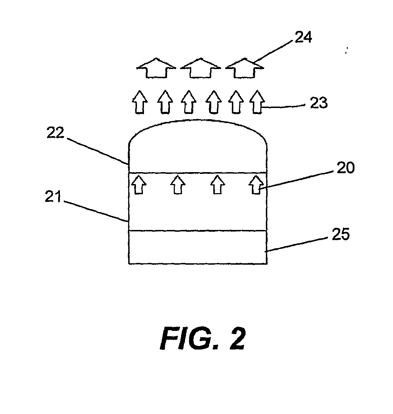

Light emitting diodes (LED) based on wide band gap semiconductor materials such as GaN/InGaN produce ultraviolet (UV) and/or blue light (300 nm - 460 nm) with high efficiency and long lifetimes [1,14]. The emission from such LEDs can be converted into lower energy radiation using the luminescence properties of phosphor materials. Therefore, high intensity blue light (10) can be used to make white LED devices by combining either a blue LED (11) and a yellow phosphor (12), as shown in FIG. 1(a), so that blue and yellow light (13) is emitted which appears as white light (14). Alternatively, a blue LED (11) emitting blue light (10), combined with green and orange phosphors (15), as shown in FIG. 1(b), emit blue, green and orange light (16) which appears as white light (14). Alternatively, a high intensity UV light (20) can be used to make white LED devices by combining a UV LED (21) with three phosphors, i.e., red, green and blue (RGB) phosphors (22), as shown in FIG. 2. The combination will emit red, green and blue light (23) which appears as white light (24). The LEDs (11),(21) may be formed on substrates (17), (25) respectively.

The first commercially available white LED was based on an InGaN chip emitting blue photons at around 460 nm combined with a Y₃Al₅O₁₂:Ce³⁺ (YAG) phosphor layer that converts blue into yellow photons [2,3]. Up to now, no competing yellow phosphor has been found to replace the YAG in the blue LED and yellow phosphor setup. However, new phosphors are necessary in order to improve efficiency as well as color rendering. The yellow phosphor should have a strong blue excitation band around 460 nm and emit yellow light around 560 nm. The second option to obtain white light requires very efficient blue, green and red phosphors that can be excited around 380 nm. The development of white solid state lighting based on UV LED requires so far new very efficient phosphor materials.

In most cases, Ce doped materials are characterized by UV emission [5]. However, high crystal field symmetries (Ce-YAG [2]) or a strongly covalent Ce environment (sulfides or oxy-nitrides [6]) can decrease the energy of the emission wavelength. Yttrium aluminium garnet (YAG) doped with Ce³⁺ is the most important example, exhibiting a strong yellow emission (540 nm) upon blue excitation (460 nm). The cubic crystal field at the Ce site associated with a small tetragonal distortion is responsible for this unusual yellow emission [2]. As demonstrated previously by Van Krevel et al. [6], it is also possible to observe green-yellow Ce³⁺ emission in oxy-nitride compounds, replacing oxygen by more covalent anion such as nitrogen. Further increases of the covalent character has lead to new Eu²⁺ doped Sialon [7,8] or silicon (oxy)nitride [9-12] based materials that have been reported to show very efficient orange luminescence. Eu²⁺ doped M₂Si₅N₈ (M=calcium, strontium, or barium) is one of the most interesting so far [10]. The longer emission wavelength observed for oxy-nitride and nitride compounds is associated with a broader excitation band that covers part of the UV and visible spectral range.

### SUMMARY OF THE INVENTION

The present invention discloses three new Ce based phosphor materials based on nitride and oxy-nitride compounds have been found that emit, respectively, yellow and blue-green photons upon UV/blue excitation. The yellow emitting compounds belong to the Ca-Al-Si-N system with distinct structures. These bright yellow phosphors can be used for white light applications by combining either a blue LED and a yellow phosphor, a blue LED and green-orange phosphors, or an UV LED with three RGB phosphors. In this regard, the present invention encompasses a number of different embodiments, which are set forth below.

In one embodiment, the present invention is an apparatus for solid state lighting applications, comprising an LED and a luminescent Ce compound comprising a Ce³⁺ doped compound from the quartenary Ca-Al-Si-N system, wherein the luminescent Ce compound emits yellow light when excited by radiation from the LED. The luminescent Ce compound may have an excitation spectrum comprising wavelengths smaller than 430 nm. In this embodiment, the radiation may be UV or blue light radiation, e.g., the LED may be a blue LED and the luminescent Ce compound may emit the yellow light for use in white light applications with the blue LED.

In another embodiment, the present invention is a composition of matter, comprising a luminescent Ce compound that emits yellow light when excited by radiation, wherein the luminescent Ce compound is a Ce³⁺ doped compound from the quartenary Ca-Al-Si-N system. In this embodiment, the radiation may be UV or blue light radiation, e.g., the luminescent Ce compound may emit the yellow light for use in white light applications with a blue light emitting diode.

The luminescent Ce compound may be based on a nitride or oxy-nitride compound and be described by the formula: MₓSi_{y}Al_{z}N_{w-δ}O_{δ}:Ce³⁺ wherein *x* ≈ *y* ≈ *z* ≈ 1, w=3, M is calcium (Ca), strontium (Sr), magnesium (Mg), or lanthanide (Ln) elements, and 0 ≤ δ < 3 and wherein alkaline earths may be substituted for M. Ce ions may be substituted for Ca with a concentration ranging from 0.01 to 20%. Yttrium (Y) or lanthanide (Ln) elements may be substituted for M with simultaneous replacement of silicon (Si) by aluminium (Al) or gallium (Ga) for charge compensation. Silicon (Si) may be partially substituted by germanium (Ge).

The luminescent Ce compound may have an orthorhombic unit cell having parameters a = 5.6477(13) Å, b = 9.5201(26) Å and c = 4.9967(13) A, wherein the values in parentheses represent uncertainty in the measurements. The luminescent Ce compound may have a broad excitation band from 375 to 475 nm with a maximum at around 420 nm, and upon excitation at 420 nm, have an emission band centered at around 540 nm with a full width at half maximum of about 100 nm from 500 to 600 nm.

The luminescent Ce compound may have an orthorhombic cell with parameters a = 9.92 Å, b = 9.11 Å and c = 7.33 Å. The composition of matter of claim 5, wherein the luminescent Ce compound has an emission maximum in the range 520-620 nm. The luminescent Ce compound may have an excitation maximum in the range 420-500nm.

In another embodiment, the present invention is a method for creating a luminescent Ce compound, comprising the steps of (a) mixing stoichiometric amounts of (1) Ca₃N₂ or Ca metal, (2) AlN, (3) Si₃N₄ or Si₂N₂NH, or Si(NH)₂, and (4) Ce to create a mixture, wherein the Ce is in the form of a metal, nitride, or oxide, (b) weighing and grinding the mixture in conditions of [O₂] < 1 parts per million (ppm) and [H₂O] < 1 ppm in order to prevent oxidation or hydrolysis, and (c) heating the mixture to a temperature between 1450°C and 1600°C under flowing hydrogen and nitrogen (H₂/N₂) with a ratio of 5:95 at 0.2 to 0.5 liters per minute. The method may further comprise mixing the stoichiometric amounts of (1) Ca₃N₂ or Ca metal, (2) AlN, (3) Si₃N₄, Si₂N₂NH or Si(NH)₂, with a Ca:Al:Si ratio of 1:1:1, and adding less than 2 % strontium.

In another embodiment, the present invention is an apparatus for solid state lighting applications, comprising an LED and a luminescent Ce compound that emits blue-green light when excited by radiation from the LED. In this embodiment, the radiation may be UV or blue light radiation, e.g., the LED may be a UV LED and the luminescent Ce compound may emit the blue-green light for use in white light applications with the UV LED in combination with RGB phosphors.

In another embodiment, the present invention is a composition of matter, comprising a luminescent Ce compound that emits blue-green light when excited by radiation. In this embodiment, the radiation may be UV or blue light radiation, e.g., the luminescent Ce compound may be used for white light applications in combination with one or more UV LEDs with RGB phosphors.

The luminescent Ce compound may be based on nitride or oxy-nitride compounds and be described by the formula M₂SiO_{4-δ}N_{δ} wherein M is strontium (Sr) and 0 ≤ δ < 4. Alkaline earths may be substituted for M and Si may be partially substituted by Ge.

The blue to green luminescent Ce compound may have an orthorhombic structure with a space group Pnmb with refined cell parameters of about a=5.6671(3) Å, b=7.0737(4) Å and c=9.7359(5) Å. The blue to green luminescent Ce compound may have an excitation peak with a width of about 80 nm, which leads to efficient excitation from 330 up to 400 nm, and may have an emission peak with a width of about 80 nm. The luminescent Ce compound may have an emission peak that is varied from 450 to 500 nm depending on synthesis conditions, a percentage of cerium or substitution of Sr by larger cations such as Ba.

The blue to green luminescent Ce compound may be prepared by (a) preparing a reactive mix of cerium doped SrO and SiO2 nanopowders by dissolution of stoichiometric amounts of Sr(NO₃)₂ and Ce(NO₃)₃ in water with Si(OC₂H₅)₄, wherein a coprecipitation of Sr and Ce oxalate at 60°C is performed in a slightly basic environment in order to gel Si(OC₂H₅)₄ and a resulting dried powder is calcined at 750°C for 2 hours, and (b) mixing the SrO thoroughly with Si₃N₄ to create a powder mixture and firing the powder mixture twice in a tube furnace at a temperature of 1350°C under flowing N₂ at 1 to 4 liters per minute.

According to a first aspect, there is provided an apparatus for solid state lighting applications, comprising: a light emitting diode (LED); and a luminescent cerium (Ce) compound comprising a Ce³⁺ doped compound from the quartenary Ca-Al-Si-N system; wherein the luminescent Ce compound emits yellow light when excited by radiation from the LED.

In the first aspect the luminescent Ce compound may have an excitation spectrum comprising wavelengths smaller than 430 nm. In the first aspect the radiation may be ultraviolet (UV) or blue light radiation. In the fist aspect the LED may be a blue LED and the luminescent Ce compound emits the yellow light for use in white light applications with the blue LED.

According to a second aspect, there is provided a composition of matter, comprising: a luminescent cerium (Ce) compound that emits yellow light when excited by radiation, wherein the luminescent Ce compound is a Ce³⁺ doped compound from the quartenary Ca-Al-Si-N system.

In the second aspect the radiation may be ultraviolet (UV) or blue light radiation. In the second aspect the luminescent Ce compound may emit the yellow light for use in white light applications with a blue light emitting diode (LED). In the second aspect the luminescent Ce compound may be based on a nitride or oxy-nitride compound. In the second aspect the luminescent Ce compound may be described by the formula: MₓSi_{y}Al₂N_{w-δ}O_{δ}:Ce₃₊ wherein x ≈ y ≈ z ≈ 1, w=3, M is calcium (Ca), strontium (Sr), magnesium (Mg), or lanthanide (Ln) elements, and 0 ≤ δ < 3, preferably wherein alkaline earths are substituted for M, or wherein cerium (Ce) ions are substituted for Ca with a concentration ranging from 0.01 to 20%, or wherein yttrium (Y) or lanthanide (Ln) elements are substituted for M with simultaneous replacement of silicon (Si) by aluminium (Al) or gallium (Ga) for charge compensation, or wherein silicon (Si) is partially substituted by germanium (Ge). In the second aspect the luminescent Ce compound may have an orthorhombic unit cell having parameters a = 5.6477(13) Å, b = 9.5201(26) Å and c = 4.9967(13) Å. In the second aspect the luminescent Ce compound may have a broad excitation band from 375 to 475 nm with a maximum at around 420 nm, preferably wherein the luminescent Ce compound, upon excitation at 420 nm, has an emission band centered at around 540 nm with a full width at half maximum of about 100 nm from 500 to 600 nm. In the second aspect the luminescent Ce compound may have an orthorhombic cell with parameters a = 9.92 Å, b=9.11 Å and c = 7.33 Å. In the second aspect the luminescent Ce compound may have an emission maximum in the range 520-620 nm, preferably wherein the luminescent Ce compound has an excitation maximum in the range 420-500nm.

In a third aspect, there is provided a method for creating a luminescent cerium (Ce) compound, comprising the steps of: (a) mixing stoichiometric amounts of (1) Ca₃N₂ or Ca metal, (2) AlN, (3) Si₃N₄, Si₂N₂NH, or Si(NH)₂, and (4) Ce to create a mixture, wherein the Ce is in the form of a metal, nitride, or oxide; (b) weighing and grinding the mixture in conditions of [O₂] < 1 parts per million (ppm) and [H₂O] < 1 ppm in order to prevent oxidation or hydrolysis; and (c) heating the mixture to a temperature between 1450°C and 1600°C under flowing hydrogen and nitrogen (H₂/N₂) with a ratio of 5:95 at 0.2 to 0.5 liters per minute.

The third aspect may further comprise mixing the stoichiometric amounts of (1) Ca₃N₂ or Ca metal, (2) AlN, (3) Si₃N₄, Si₂N₂NH or Si(NH)₂, with a Ca:Al:Si ratio of 1:1:1, and adding less than 2 % strontium.

In an embodiment according to claim 1 the radiation is ultraviolet (UV) or blue light radiation.

These embodiments are described in more detail below.

### BRIEF DESCRIPTION OF THE DRAWINGS

Referring now to the drawings in which like reference numbers represent corresponding parts throughout:
FIGS. 1(a) and 1(b) are schematic representations of a white LED setup based on a blue LED (∼460 nm) with a yellow phosphor, as shown in FIG. 1(a), or with a mix of green and orange phosphors, as shown in FIG. 1(b).
FIG. 2 is a schematic representation of the white LED setup based on a UV LED (∼380 nm) with red, green and blue (RGB) phosphor materials.
FIG. 3 is a flowchart illustrating the preparation of a yellow phosphor comprising a luminescent Ce compound based on nitride compounds.
FIG. 4 is a graph of the emission/excitation spectra of the compound CaAlSiN₃ doped with Ce³⁺, wherein the emission wavelength maximum is ∼540 nm and the excitation wavelength has been fixed at -420 nm.
FIG. 5 is a flowchart illustrating the preparation of a second phase of a yellow phosphor comprising a luminescent compound.
FIG. 6 is a graph of an X-ray diffraction pattern of the Ce³⁺ doped CaₓSi_{y}Al_{z}N_{3-δ}O_{δ} yellow phosphor.
FIG. 7 is a graph of the emission/excitation spectra of the new Ce³⁺ doped CaₓSi_{y}Al_{z}N_{3-δ}O_{δ} yellow phosphor, wherein the excitation wavelength is -460 nm and the emission wavelength has been fixed at ∼565 nm.
FIG. 8 shows how the composition of matter comprising the blue-green phosphor has been synthesized via a two step method.
FIG. 9 is a graph of an X-ray diffraction pattern of the Ce³⁺ doped Sr₂SiO_{4-δ}N_{δ} blue-green phosphor.
FIG. 10 is a graph of the emission spectrum of the compound Sr₂SiO₄ doped with Ce³⁺, wherein the excitation wavelength is 380 nm and the emission wavelength has been fixed at 460 nm.
FIG. 11 is a schematic representation of an apparatus for solid state lighting applications, comprising an LED and a composition of matter comprising a luminescent Ce compound.

### DETAILED DESCRIPTION OF THE INVENTION

In the following description of the preferred embodiment, reference is made to the accompanying drawings that form a part hereof, and in which is shown by way of illustration a specific embodiment in which the invention may be practiced. It is to be understood that other embodiments may be utilized and structural changes may be made without departing from the scope of the present invention.

### Technical Disclosure

The subject of the present invention is the discovery of three new phosphor materials for application in white solid-state lighting based upon blue (InGaN) or UV (GaN, ZnO) LEDs. Hence, the invention covers the synthesis of yellow and blue to green emitting materials and their application as a phosphor alone or in combination with other phosphors for white LED realization. Two compositions of matter comprising Ce³⁺ doped compounds from the quaternary Ca-Al-Si-N system are reported to emit yellow photons under UV or blue excitation, and cerium doped Sr₂SiO_{4-δ}N_{δ} is reported to emit blue to green light.

The composition of matter comprising the yellow phosphor belongs to the quaternary system comprising calcium- aluminium- silicon- nitrogen (Ca-Al-Si-N) and can be described by the formula MₓSi_{y}Al_{z}N_{w-δ}O_{δ}:Ce³⁺ with *x* ≈ *y* ≈ *z* ≈ 1, w=3 and 0 ≤ δ < 3. If δ is 0, the compound is an example of a nitride compound; if δ is non zero, the compound is an example of an oxy-nitride. M is calcium (Ca), but chemical substitution on the M site is possible with different alkaline earths. Ce ions are substituted on the Ca site with a concentration ranging from 0.01 to 20%. Yttrium (Y) or lanthanide (Ln) elements may also be substituted on the M site with simultaneous replacement of silicon (Si) by aluminium (Al) or gallium (Ga) atoms for charge compensation. Silicon (Si) atoms may also be partially substituted using germanium (Ge).

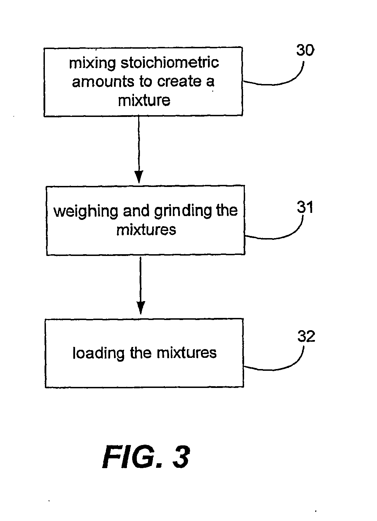

FIG. 3 shows how the composition of matter comprising the first yellow phosphor (nitride based CaAlSiN₃:Ce³⁺ phase) may be prepared.

Block 30 represents the step of mixing stoichiometric amounts of (1) Ca₃N₂ or Ca metal, (2) AlN, (3) Si₃N₄, Si₂N₂NH or Si(NH)₂, with (4) the Ce source in the form of either a metal, nitride (if available), or oxide, to create a mixture.

Block 31 represents the step of weighing and grinding of the mixture, carried out in a glove box in conditions of [O₂] < 1 ppm and [H₂O] < 1 ppm in order to prevent degradation such as oxidation or hydrolysis.

Block 32 represents the step of loading the mixture into, for example, a boron nitride (BN) crucible, for heating in a tube furnace temperature between 1450 °C and 1600°C under flowing hydrogen (H₂) and nitrogen (N₂) with a ratio of 5:95 (0.2 to 0.5 liters per minute). The body color of this material is bright yellow.

X-ray powder diffraction (see Table 1) shows that this first phase comprising CaAlSiN₃:Ce³⁺ prepared using FIG. 3 is similar to the previously reported CaAlSiN₃ [12]. Using Table 1, and based on an orthorhombic unit cell, the refined values of the parameters are a = 5.6477(13) A, b = 9.5201 (26) Å, c=4.9967(13) Å for the first phase of a yellow phosphor comprising CaAlSiN₃. :

The compound CaAlSiN₃ has already been shown to be a very efficient orange/red phosphor if Ca²⁺ ions are substituted by Eu²⁺ [13]. Due to the presence of additional phases, the structure of CaAlSiN₃ has not yet been determined and the symmetry is thought to be orthorhombic with cell parameters of about a = 5.63 Å, b = 9.58 Å and c = 4.986 Å [12].

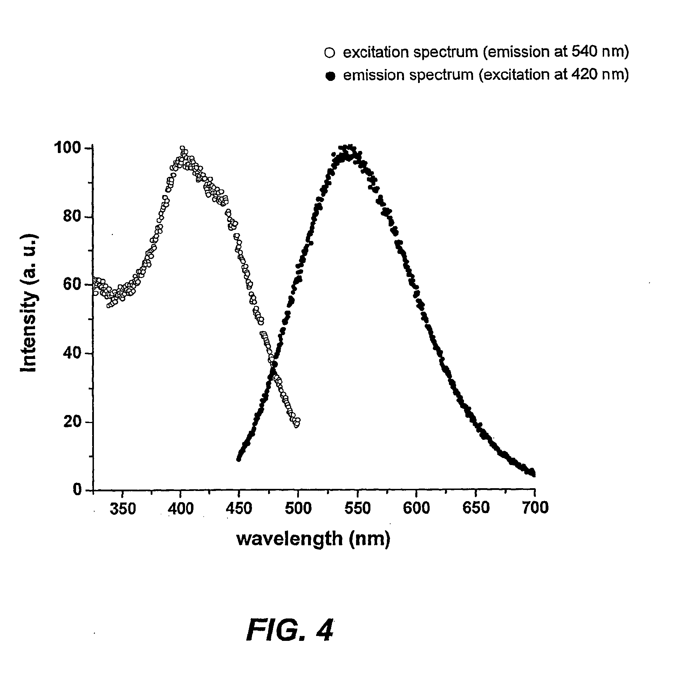

The luminescent properties of the first yellow phosphor are particularly interesting for white light applications. FIG. 4 shows an example of how a composition of matter comprising a luminescent Ce doped compound from the Ca-Al-Si-N system emits yellow light when excited by radiation, for example UV or blue radiation. According to FIG. 4, the Ce doped CaAlSiN₃ has a broad excitation band from 375 nm to 475 nm with a maximum at around 420 nm. According to FIG. 4, upon excitation at 420 nm, the emission band is centered at around 540 nm with a full width at half maximum of about 100 nm from 500 nm to 600 nm.

Hence, FIG. 4 shows how the luminescent Ce compound can be a promising alternative to YAG:Ce3⁺ for the application as the yellow phosphor. First, the broad excitation band can be efficiently excited with a blue InGaN LED around 460 nm. Second, the Ce compound can be excited as well by a near UV GaN, ZnO LED for a three phosphor RGB setup. Third, this material shows a broader excitation band of about 100 nm whereas cerium YAG shows only a 60 nm wide band ranging from 430 nm to 490 nm.

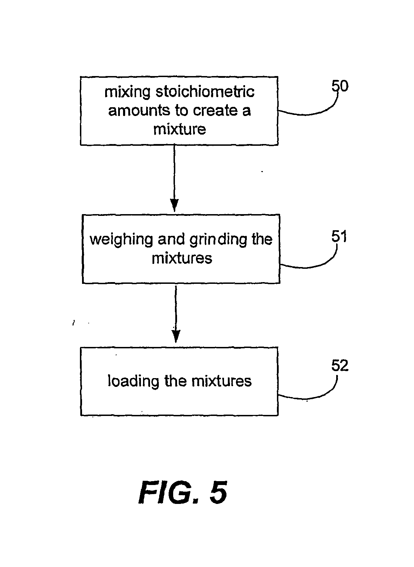

FIG. 5 shows how the second yellow phosphor comprising a second phase of the Ca-Al-Si-N system (CaₓSi_{y}Al_{z}N_{3-δ}O_{δ}:Ce³⁺) can be prepared.

Block 50 represents the step of mixing stoichiometric amounts of (1) Ca₃N₂ or Ca metal, (2) AlN, and (3) Si₃N₄, Si₂N₂NH or Si(NH)₂, with a Ca:Al:Si ratio of 1:1:1, together with (4) a Ce source in the form of either a metal, nitride (if available) or oxide, to create a mixture. A small amount of Sr (less than 2 %) is added.

Block 51 represents the step of weighing and grinding of the mixture, carried out in a glove box in conditions of [O₂] < 1 ppm and [H₂O] < 1 ppm in order to prevent degradation such as oxidation or hydrolysis.

Block 52 represents the step of loading the mixture into, for example, a BN crucible for heating in a tube furnace temperature between 1450 °C and 1600°C under flowing H₂/N₂ with a ratio of 5:95 at 0.2 to 0.5 liters per minute. The body color of this material is bright yellow.

Even though the stoichiometry is close to that of the composition of matter comprising the first yellow phosphor (CaAlSiN₃:Ce³⁺), the structure is rather different (see Tables 1 and 2 below). Strontium impurities and/or variations of heating conditions may explain the changes of structure.

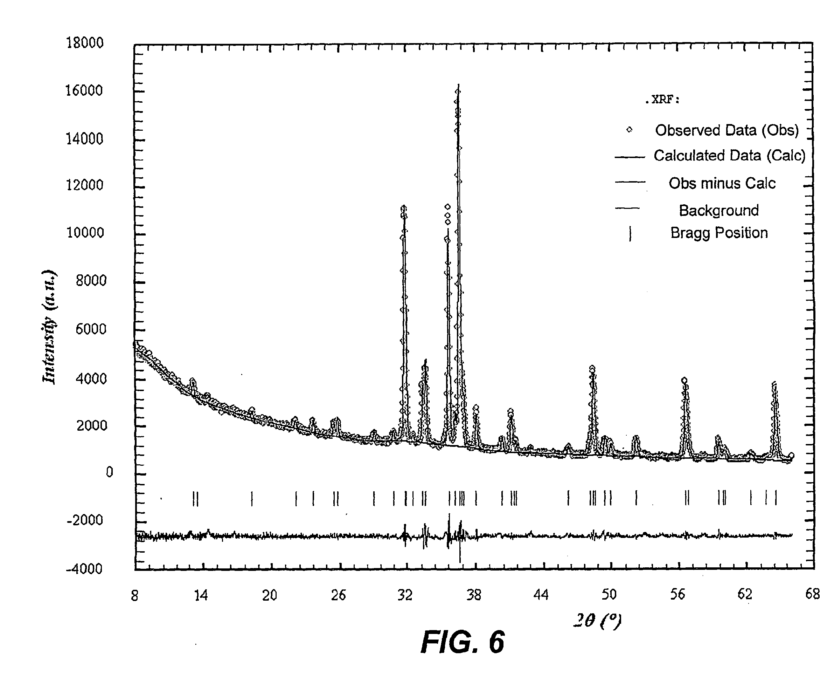

FIG. 6 and Table 2 show this newly discovered CaₓSi_{y}Al_{z}N_{3-δ}O_{δ}:Ce³⁺ phase, created using the method of FIG. 5, has a different X-ray powder pattern. According to FIG. 6 and Table 2, the structure may be described with an orthorhombic cell with parameters a = 9.92 Å, b = 9.11 Å and c = 7.33 Å.

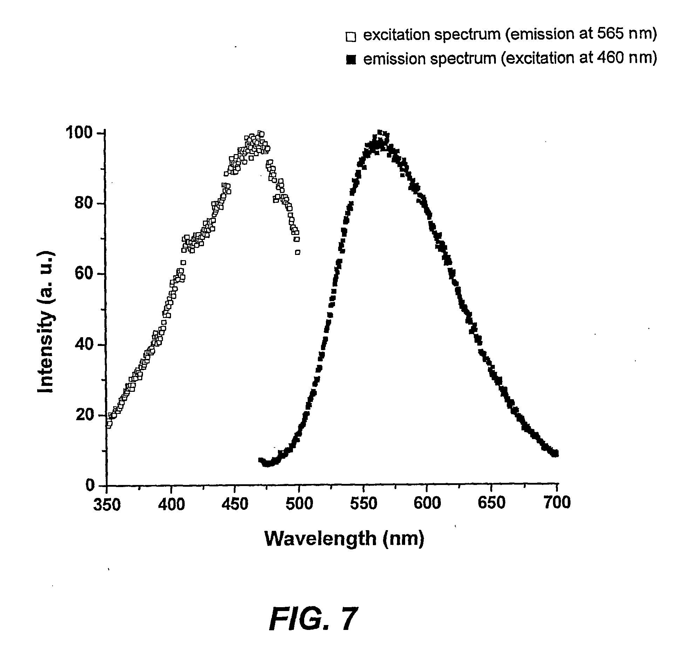

FIG. 7 illustrates a further example of how a luminescent Ce doped compound from the Ca-Al-Si-N system, the new CaₓSiyAl_{z}N_{3-δ}O_{δ}:Ce³⁺ phase, emits yellow light when excited by radiation such as blue or UV light.

FIGS. 4 and 7 show how the structural changes between CaAlSiN₃:Ce³⁺ and the CaₓSi_{y}Al_{z}N_{3-δ}O_{δ}:C³⁺ phase translate into a red shift of both emission and excitation bands. The emission maximum is around 565 nm for the CaₓSi_{y}Al_{z}N₃. _{δ}O_{δ}:Ce³⁺ phase, as illustrated in FIG.7. Both compounds (CaAlSiN₃:Ce³⁺ and the new CaₓSi_{y}Al_{z}N_{3-δ}O_{δ}:Ce³⁺ phase) present a comparable emission peak shape and full width at half maximum, as illustrated in FIGS. 4 and 7_{.} For the CaₓSi_{y}AlN_{3-δ}O_{δ}:Ce³⁺ phase, the excitation maximum is at around 460 nm, but the excitation band covers the range 350 nm to 500nm, as illustrated in FIG. 7. The CaₓSi_{y}AlN_{3-δ}O_{δ}:Ce³⁺ phase is thus very suitable for the yellow phosphor and blue LED setup. FIG. 7 also shows the Ce doped compound can also been used with a UV excitation source such as GaN or ZnO LED.

The tail of the emission peak, shown in FIG. 7, that extends well over 630 nm can also be very advantageous for color rendering purposes.

The composition of the blue-green light emitting phosphor may be M₂SiO₄-_{δ}N_{δ}, where M is mainly strontium (Sr), but chemical substitution on the M site is possible with different alkaline earths, magnesium (Mg), Ca, barium (Ba) or even zinc (Zn), and with 0 ≤ δ < 4. Silicon atoms may also be partially substituted using Ge. If δ is 0, the compound is an example of a nitride compound; if δ is non zero, the compound is an example of an oxy-nitride.

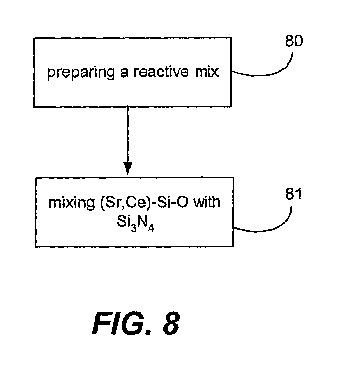

FIG. 8 shows how the composition of matter comprising the blue and green phosphor has been synthesized via a two step method.

Block 80 represents the step of preparing a reactive mix of cerium doped SrO and SiO₂ nanopowders by dissolution of stoichiometric amounts of Sr(NO₃)₂ and Ce(NO₃)₃ in water with Si(OC₂H₅)₄, wherein a co-precipitation of Sr and Ce oxalate at 60°C is performed in a slightly basic environment in order to gel Si(OC₂H₅)₄, and a resulting dried powder is calcined at 750°C for 2 hours.

Block 81 represents the step of mixing the (Sr,Ce)-Si-O thoroughly with Si₃N₄ to create a mixture, and placing the mixture into, for example, an Al₂O₃ boat, wherein a resulting powder is fired twice in a tube furnace at 1350°C under flowing nitrogen (N₂) at 1 to 4 liters per minute. The body color of this material is light green.

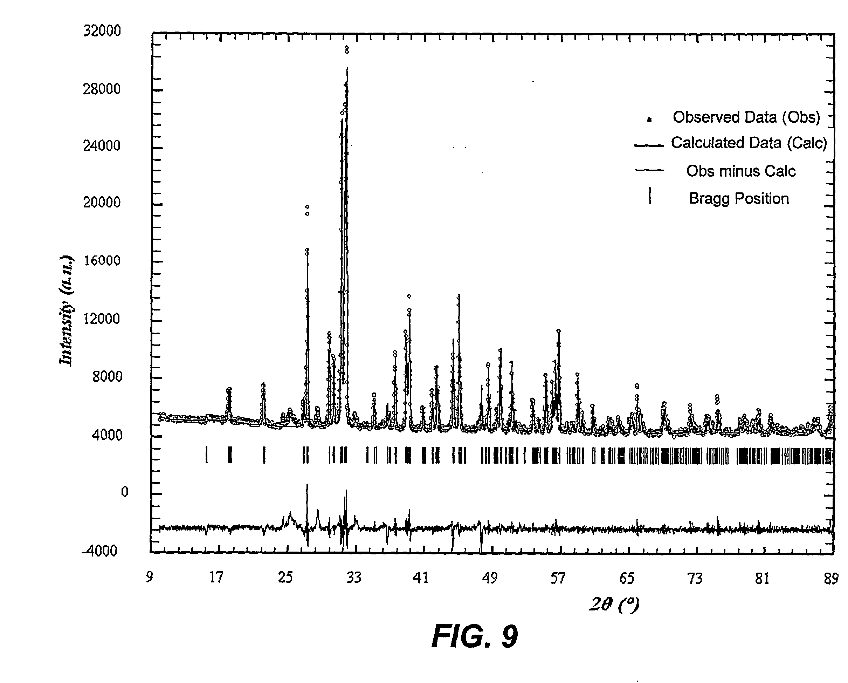

All samples have been characterized using X-ray diffraction and UV/visible emission excitation spectroscopy. FIG. 9 shows the phase Sr₂SiO_{4-δ}N_{δ} has an orthorhombic structure with a space group Pnmb with refined cell parameters of about a = 5.6671(3) Å, b = 7.0737(4) Å, c = 9.7359(5) Å.

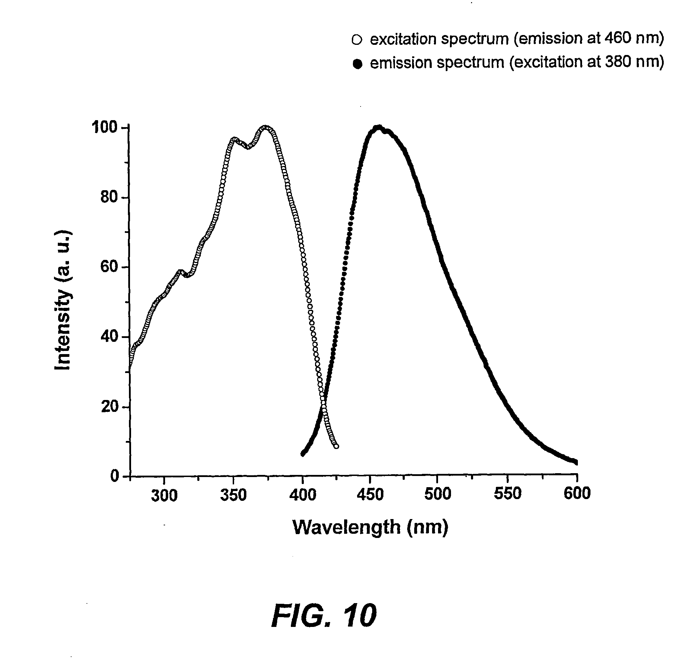

FIG. 10 shows an example of how a composition of matter comprising a luminescent Ce doped compound emits blue to green light when excited by radiation (such as blue or UV) from the LED. According to FIG. 10, the Sr₂SiO₄:Ce³⁺ phosphor may be used as a blue to green phosphor for solid-state lighting based upon RGB and UV LEDs. The very bright Sr₂SiO₄:Ce³⁺compound can be excited in the UV (∼380 nm) using GaN or ZnO based LEDs, as illustrated in FIG. 10. FIG. 10 also shows the excitation peak has a width of about 80 nm which leads to efficient excitation in an excitation spectrum covering 330 nm up to 400 nm. The emission peak may be varied from 450 nm to 500 nm depending on the synthesis conditions, the percentage of cerium or the substitution of Sr by larger cations such as Ba. The emission peak at ∼460 nm has a width of about 80 nm, as shown in FIG. 10.

The optical properties of Sr₂SiO₄ as a host material have already been reported for Eu²⁺ emission [2].

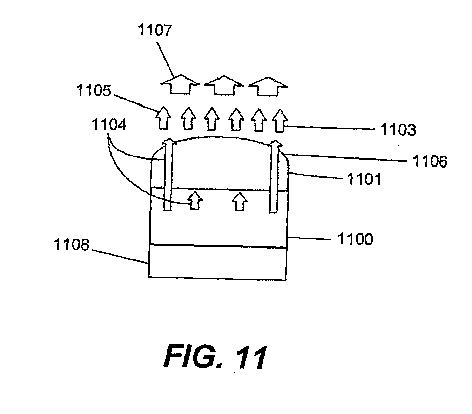

FIG. 11 is a schematic representation, analogous to FIGS. 1 and 2, of an apparatus for solid state lighting applications (for example a white light application), comprising at least one LED (1100) and a composition of matter comprising a luminescent Ce doped compound (1101) typically positioned adjacent the LED, that emits yellow or blue to green light (1103) when excited by radiation (1104) from the LED. Other colored light (1105) may be present if one or more other phosphors (1106) are incorporated, such as the phosphors of FIGS 1 and 2. For example, the other phosphors (1106) may comprise green and orange phosphors, or red, green and blue phosphors. The radiation (1104) may comprise blue light or UV light. Some examples are outlined below:

When the LED (1100) is a blue LED, the luminescent Ce compound emits the yellow light (1103) for use in white light applications with the blue LED (and optionally other phosphors (1106)), because the blue light (1104) in combination with the yellow light (1103) and light (1105) from other phosphors (1106) if present, appears as white light (1107).

When the LED (1100) is a blue LED, the luminescent Ce compound emits yellow light (1103) for use in white light applications with the blue LED and other phosphors (1106), because the blue light (1104) in combination with the green/orange light (1105) from other phosphors (1106) appears as white light (1107).

When the LED (1100) is an UV LED, the luminescent Ce compound (1101) emits the yellow light (1103) for use in white light applications with the UV LED and RGB phosphors (1106), because the red, green and blue light (1103) from the RGB (1106) and the yellow light from the Ce compound appears as white light (1107).

When the LED (1100) is an UV LED, the luminescent Ce compound (1101) emits the blue to green light (1103) for use in white light applications with the UV LED and RGB phosphors (1106), because the red, green and blue light (1105) from the RGB (1106) and the blue-green light (1103) from the luminescent Ce compound appears as white light (1107).

The luminescent Ce compound (1101) may be based on nitride or oxy-nitride compounds. The LED may be formed on a substrate (1108).

### References

The following references are incorporated by reference herein:
[1] S. Nakamura, G. Fasol, The Blue Laser Diode: GaN Based Light Emitters and Lasers, Springer, Berlin (1997).
[2] G. Blasse and A. Brill, Appl. Phys. Lett., 11 (1967): J. Chem. Phys., 47 (1967) 5139. Phosphor Handbook, S. Shionoya, W. M. Yen.(1998).
[3] U.S. Patent No. 5,998,925, issued December 7, 1999, to Shimizu. et al., and entitled "Light emitting device having a nitride compound semiconductor and a phosphor containing a garnet fluorescent material."
[4] T. Justel, H. Nikol, C. Ronda, Angew. Chem. Int. Ed., 1998, 37, 3084-3103.
[5] G. Blasse, B. C. Grabmeier, Luminescent Materials, Springer, Berlin (1994).
[6] J. W. H. van Krevel, H. T. Hintzen, R. Metselaar, A. Meijerink, J. Alloys Compd. 268 (1-2), 272-277 (1998).
[7] U.S. Patent No. 6,717,353, issued April 6, 2004, to Mueller et al., and entitled "Phosphor converted light emitting device."
[8] J. W. H. van Krevel, J. W. T. van Rutten, H. Mandal, H. T. Hinzen, R. Metselaar, J. Solid State Chem. 165 (1) 19-24 (2002).
[9] U.S. Patent No. 6,670,748, issued December 30, 2003, to Ellens et al., and entitled "Illumination unit having at least one LED as light source."
[10] U.S. Patent No. 6,682,663, issued January 27, 2004, to Botty et al., and entitled "Pigment with day-light fluorescence."
[11] U.S. Patent Publication No. 20030006702, published January 9, 2003, by Regina B. Mueller-Mach et al., and entitled "Red-deficiency compensating phosphor light emitting device."
[12] Z. K. Huang, W. Y. Sun, D. S. Yan, Journal of Materials Science Letters 4 (1985) 255-259.
[13] K. Uheda, N. Hirosaki, H. Yamamoto, H. Yamane, Y. Yamamoto, W. Inami, K. Tsuda, Proceeding of the 2004 Joint Research Meeting, ECS October 2004, Y1-Thirteen International Symposium on the Physics ad Chemistry of Luminescent Materials.
[14] S. P. DenBaars, Solid State Luminescence Theory, Materials and Devices, edited by A. H. Kitai, Chapman and Hall, London (1993).

### Conclusion

This concludes the description of the preferred embodiment of the present invention. The foregoing description of one or more embodiments of the invention has been presented for the purposes of illustration and description. It is not intended to be exhaustive or to limit the invention to the precise form disclosed. Many modifications and variations are possible in light of the above teaching without fundamentally deviating from the essence of the present invention. It is intended that the scope of the invention be limited not by this detailed description, but rather by the claims appended hereto.

**Table 1: d-spacing for the Ce³⁺ doped CaAlSiN₃ compound obtained from X-ray powder diffraction.**

| **2**ϑ | **d-spacing** | **Intensity** |
|---|---|---|
| 17.736 | 4.996687 | 14 |
| 18.25 | 4.857327 | 34 |
| 18.626 | 4.760084 | 119 |
| 25.555 | 3.482875 | 205 |
| 25.83 | 3.446498 | 150 |
| 31.66 | 2.823873 | 337 |
| 32.333 | 2.766574 | 997 |
| 35.917 | 2.498344 | 846 |
| 36.52 | 2.458431 | 1000 |
| 36.984 | 2.428664 | 285 |
| 37.116 | 2.420344 | 618 |
| 37.768 | 2.380042 | 162 |
| 40.573 | 2.221693 | 0 |
| 40.756 | 2.212162 | 17 |
| 41.299 | 2.18431 | 221 |
| 42.015 | 2.148735 | 0 |
| 48.62 | 1.871151 | 126 |
| 49.094 | 1.854193 | 239 |
| 49.303 | 1.846819 | 52 |
| 50.083 | 1.819872 | 26 |
| 50.546 | 1.804258 | 28 |
| 52.506 | 1.741438 | 13 |
| 52.805 | 1.732282 | 30 |
| 53.103 | 1.723249 | 34 |
| 53.548 | 1.709985 | 16 |
| 53.99 | 1.697013 | 24 |
| 55.095 | 1.665563 | 14 |
| 56.817 | 1.619109 | 378 |
| 58.087 | 1.586695 | 112 |
| 58.539 | 1.575513 | 40 |
| 58.679 | 1.572103 | 0 |
| 60.014 | 1.540264 | 33 |
| 61.243 | 1.512279 | 0 |
| 62.488 | 1.485106 | 1 |
| 63.157 | 1.470985 | 16 |
| 63.556 | 1.462703 | 2 |
| 64.951 | 1.434614 | 269 |
| 65.344 | 1.426928 | 186 |
| 66.126 | 1.411936 | 43 |

**Table 2: d-spacing for the new Ce³⁺ doped CaₓSi_{y}Al_{z}N_{w-δ}O_{δ} phase obtained from X-ray powder diffraction**

| **2**ϑ | **d-spacing** | **Intensity** |
|---|---|---|
| 13,143 | 6,73086083 | 36 |
| 13,4943 | 6,55641426 | 5 |
| 18,2506 | 4,85705447 | 18 |
| 22,047 | 4,02852137 | 23 |
| 23,6037 | 3,76623879 | 31 |
| 25,4389 | 3,49854329 | 31 |
| 25,7445 | 3,45770252 | 50 |
| 28,9833 | 3,07825831 | 24 |
| 30,7726 | 2,90322548 | 24 |
| 31,7727 | 2,81408597 | 549 |
| 31,8884 | 2,80413918 | 221 |
| 32,4779 | 2,7545751 | 12 |
| 33,3463 | 2,68479878 | 155 |
| 33,5926 | 2,66567486 | 224 |
| 35,6149 | 2,51880928 | 597 |
| 36,1652 | 2,48173449 | 73 |
| 36,5413 | 2,45704973 | 1000 |
| 36,7261 | 2,4451093 | 184 |
| 36,9422 | 2,43130083 | 116 |
| 38,038 | 2,36374133 | 98 |
| 40,2696 | 2,23774793 | 42 |
| 41,0968 | 2,19459627 | 113 |
| 41,5258 | 2,17290997 | 17 |
| 41,3686 | 2,18080308 | 26 |
| 46,1567 | 1,96510355 | 26 |
| 48,1231 | 1,88929703 | 42 |
| 48,4116 | 1,87871008 | 266 |
| 48,5471 | 1,87378263 | 43 |
| 49,4325 | 1,84227326 | 64 |
| 49,924 | 1,82528156 | 37 |
| 52,1626 | 1,75209125 | 70 |
| 56,5341 | 1,62654061 | 295 |
| 56,7871 | 1,61989319 | 51 |
| 59,468 | 1,55310549 | 66 |
| 59,8727 | 1,543571 | 26 |
| 60,0577 | 1,53925775 | 19 |
| 62,3297 | 1,4884962 | 24 |
| 64,4856 | 1,44383901 | 336 |
| 64,7032 | 1,43950805 | 11 |

## Claims

1. An apparatus for solid state lighting applications, comprising:
a light emitting diode (LED); and
a luminescent cerium (Ce) compound that emits blue-green light when excited by radiation from the light emitting diode.

2. The apparatus of claim 1, wherein the LED is an ultraviolet (UV) LED and the luminescent Ce compound emits the blue-green light for use in white light applications with the UV LED in combination with red, green and blue (RGB) phosphors.

3. A composition of matter, comprising:
a luminescent cerium (Ce) compound that emits blue-green light when excited by radiation.

4. The composition of matter of claim 3, wherein the radiation is ultraviolet (UV) or blue light radiation.

5. The composition of matter of claim 3, wherein the luminescent Ce compound is used for white light applications in combination with one or more ultraviolet (UV) light emitting diodes (LEDs) with red, green and blue (RGB) phosphors.

6. The composition of matter of claim 3, wherein the luminescent Ce compound is based on a nitride or oxy-nitride compound.

7. The composition of matter of claim 3, wherein the luminescent Ce compound is described by the formula:
M₂SiO_{4-δ}N_{δ}
wherein M is strontium (Sr) and 0 ≤ δ 4.

8. The composition of matter of claim 7, wherein alkaline earths are substituted for M.

9. The composition of matter of claim 7, wherein silicon (Si) is partially substituted by germanium (Ge).

10. The composition of matter of claim 3, wherein the luminescent Ce compound has an orthorhombic structure with a space group Pnmb with refined cell parameters of about a = 5.6671 (3) Å, b = 7.0737(4) Å and c = 9.7359(5) Å.

11. The composition of matter of claim 3, wherein the luminescent Ce compound has an excitation peak with a width of about 80 nm, which leads to efficient excitation from 330 up to 400 nm.

12. The composition of matter of claim 3, wherein the luminescent Ce compound has an emission peak that is varied from 450 to 500 nm depending on synthesis conditions, a percentage of Ce or substitution of Sr by larger cations such as Ba.

13. The composition of matter of claim 3, wherein the luminescent Ce compound has an emission peak with a width of about 80 nm.

14. The composition of matter of claim 3, wherein the luminescent Ce compound is prepared by:
preparing a reactive mix of Ce doped SrO and SiO₂ nanopowders by dissolution of stoichiometric amounts of Sr(NO₃)₂ and Ce(NO₃)₃ in water with Si(OC₂H₅)₄, wherein a coprecipitation of Sr and Ce oxalate at 60°C is performed in a slightly basic environment in order to gel Si(OC₂H₅)₄ and a resulting dried powder is calcined at 750°C for 2 hours; and
mixing the (Sr,Ce)-Si-O thoroughly with Si₃N₄ to create a powder mixture and firing the powder mixture twice in a tube furnace at a temperature of 1350°C under flowing N₂ at 1 to 4 liters per minute.
